# NEUE EUROPÄISCHE PATENTSCHRIFT

(11) **EP 3 066 430 B2**
(45) Veröffentlichungstag und Bekanntmachung des Hinweises auf die Entscheidung über den Einspruch: **30.08.2023**
(45) Hinweis auf die Patenterteilung: 04.04.2018
(21) Anmeldenummer: 14786806.1
(22) Anmeldetag: 22.10.2014
(51) Int. Cl.: G01G 21/28, G01G 23/48, G01G 17/04

(54) **WAAGE ZUR KALIBRIERUNG VON PIPETTEN**
BALANCE FOR CALIBRATING PIPETTES
BALANCE D'ÉTALONNAGE DE PIPETTES

(30) Priorität: 08.11.2013 DE 102013018767; 07.02.2014 DE 102014101566
(43) Veröffentlichungstag der Anmeldung: 14.09.2016
(73) Patentinhaber: Sartorius Lab Instruments GmbH & Co. KG, 37079 Göttingen (DE)
(72) Erfinder: GRAF, Winfried, 37127 Niemetal (DE); ELO, Christian, 12247 Berlin (DE)
(74) Vertreter: Prinz & Partner mbB
(86) Internationale Anmeldenummer: PCT/EP2014/002852
(87) Internationale Veröffentlichungsnummer: WO 2015/067349

(56) Entgegenhaltungen:
- EP-A1- 1 975 577
- EP-A1- 2 251 657
- EP-A2- 1 092 473
- WO-A1-2013/163612
- DE-A1-102010 042 621
- DE-U1-202004 000 590

## Beschreibung

Die Erfindung betrifft eine Waage, die zur Kalibrierung von Pipetten verwendet wird, sowie ein Verfahren zur Kalibrierung einer Pipette.

Für die gravimetrische Kalibrierung von Pipetten werden hochauflösende Präzisions-, Analysen-, Semi-Mikro-, Mikro- oder Ultramikrowaagen, nachfolgend als Waagen bezeichnet, verwendet. Beim gravimetrischen Kalibrieren des Nennvolumens von Pipetten mithilfe einer Waage wird ein zu bestimmendes Flüssigkeitsvolumen aus der Pipettenspitze in ein Wiegegefäß abgegeben und mithilfe des Wägewertes das Volumen der abgegebenen Flüssigkeitsmenge bestimmt. Dabei ist bekannt, weitere Parameter wie die Lufttemperatur, die Flüssigkeitsdichte, die Luftfeuchte sowie den Luftdruck zu berücksichtigen, da diese Parameter sich auf den Wägewert auswirken. Beispielsweise haben Lufttemperatur und Luftfeuchte einen Einfluss auf die Verdunstungsrate der Prüfflüssigkeit.

Standardmäßig werden Volumina bis 1 µl kalibriert. Gerade bei kleinsten Volumina ist der Einfluss der Flüssigkeitsverdunstung und somit der Fehler auf das Wägeergebnis und die Genauigkeit der Kalibrierung der Pipette nicht zu vernachlässigen.

Um die Verdunstung der Prüfflüssigkeit während der Wägung klein zu halten, werden in Pipettenkalibrieranwendungen sogenannte Verdunstungsfallen verwendet, die im Wägeraum angeordnet sind. Diese Verdunstungsfallen sind mit Wasser gefüllt, was durch Verdunstung für eine hohe Sättigung des Luftvolumens im Wägeraum mit Wasser sorgt. Auf diese Weise können relative Luftfeuchten bis zu 90 % erreicht werden.

Trotzdem kann auch bei Verwendung von Verdunstungsfallen nicht ganz verhindert werden, dass ein Teil der Prüfflüssigkeit während des Kalibriervorgangs verdunstet. Grund hierfür ist, dass der Pipettiervorgang selbst zu Luftbewegungen und zu einem Luftaustausch zwischen Wägeraum und der Umgebung führt, durch den die Sättigung des Luftvolumens schwankt.

Hinzu kommt, dass bei einer Waage ein valider Messwert nicht sofort erhalten werden kann, nachdem die zu kalibrierende Pipette ein bestimmtes Flüssigkeitsvolumen abgegeben hat, sondern dass eine gewisse Zeit gewartet werden muss. Diese Zeitdauer soll im Hinblick auf die Verfälschung durch Verdunstung unterhalb von 60 Sekunden liegen. Erfahrungsgemäß beträgt die Zeitdauer, abhängig von Auflösung, Handling und Typ der Waage, in der Größenordnung von 5 bis 20 Sekunden. Es lässt sich nicht verhindern, dass während dieser Prozesszeit bereits ein Teil der zu messenden Flüssigkeit verdunstet und dadurch das Messergebnis verfälscht. Dieser Effekt macht sich bei kleinen Volumina überproportional bemerkbar.

Im Stand der Technik ist daher bekannt, dass der Wägewert mittels einer angenommenen Verdunstungsrate korrigiert wird. Solche Verdunstungsraten sind für bestimmte Gefäßgeometrien und Werte der relativen Feuchte innerhalb des Wägeraums experimentell bestimmt worden und liegen beispielsweise zwischen 0,05 µg/s beim Pipettieren in einen Enghalskolben unter Verwendung einer Verdunstungsfalle, die bei geschlossenem Wägeraum eine relative Feuchte von 90 % gewährleistet, und beispielsweise 4,6 µg/s beim Pipettieren in ein Becherglas wiederum unter Verwendung einer Verdunstungsfalle, die allerdings bei offenem Wägeraum eine relative Feuchte unterhalb von 90 % hervorruft. Diese Werte gelten für destilliertes oder deionisiertes Wasser der Qualität 3 nach ISO 3696 als Pipettierflüssigkeit. Bei der Kalibrierung von Pipetten wird allgemein ein fester Wert für die Verdunstung angenommen.

Es lässt sich leicht erkennen, dass der Einfluss der Verdunstung auf den Messfehler nicht vernachlässigbar ist. Bei einer angenommenen Verdunstungsrate von 0,26 µg/s ergibt sich bei einer Prozesszeit von 12 Sekunden für Handling und Einschwingen der Waage ein Verdunstungsvolumen von 3,12 µl. Die Standardmessunsicherheit gemäß EN-ISO 8655-6 in einem Messbereich von 1 µl bis 10 µl beträgt 2 µl. Die angenommene Verdunstung ist also größer als der Messfehler. Dabei handelt es sich bei der angenommenen Verdunstungsrate von 0,26 µg/s noch um einen eher geringen Wert; in der Literatur werden teilweise deutlich höhere Werte genannt.

Um den Einfluss der Umgebung auf die Messgenauigkeit zu verringern, sind im Stand der Technik für die Massebestimmung verschiedene Maßnahmen bekannt.

Für Komparatorwaagen ist bekannt, dass der Luftauftrieb durch eine Vergleichsmessung zwischen zwei Referenzobjekten bestimmt wird, deren Masse und Dichte vorbekannt sind.

Es ist bekannt, dass Temperatur, Luftdruck und Feuchte die Waage selbst beeinflussen. Aus diesem Grund werden zur Kompensation der Veränderungen des Wägewertes bei veränderten Umgebungsparametern Korrekturfaktoren im Gerät abgelegt, zum Beispiel in Form von Kurven oder Tabellen. Hierzu werden im Umfeld der Wägezelle, z. B. im Labor, Temperatur- und Luftfeuchtesensoren angeordnet, über die dann eine Korrektur der Waage selbst in Abhängigkeit von den sich ändernden Umgebungsbedingungen automatisch erfolgt.

Aus der EP 1 975 577 A1 ist eine Waage zur gravimetrischen Kalibrierung von Pipetten bekannt, die über einen Windschutz und eingebaute Temperatur-, Luftdruck- und Luftfeuchtesensoren verfügt.

Die DE 37 14 540 C2 beschreibt ein Verfahren zum automatischen Kalibrieren einer hochauflösenden, elektronischen Waage, bei der für die Kalibrierung der Waage selbst Umgebungseinflüsse wie Temperaturänderung und Feuchtigkeitsänderung herangezogen werden, die extern erfasst werden. Der entsprechende Kalibrierfaktor wird von einem Computer ermittelt und korrigiert das Wägeresultat.

Aus der DE 299 12 867 U1 ist eine Analysenwaage mit Messwertaufnehmer für Umgebungsparameter bekannt, bei der eine Anzeige auf der Rückwand des Wägeraums vorgesehen ist. In dieser Anzeige werden die Temperatur im Wägeraum und die Luftfeuchte im Wägeraum angezeigt sowie allgemein der generell herrschende Luftdruck. Es wird dabei davon ausgegangen, dass bei einer feuchten Luft eine Feuchtebelegung der Oberfläche des Wägeguts erfolgt, die abhängig von den Änderungen der Luftfeuchte ist. Somit ist die Bedienperson über die Anzeige darüber informiert, dass beispielsweise bei sich ändernder Luftfeuchte das Wägegut länger im Wägeraum liegen sollte, um einen stabilen Endwert der Feuchtebelegung zu erreichen. Ergeben sich starke Luftdruckänderungen, so kann die Bedienperson eine sogenannte Auftriebskorrektur vornehmen, indem sie die angezeigten Daten über eine Eingabeeinheit dem Prozessor in der Waage liefert. Was die Temperatur anbelangt, so dient diese dazu, die Abweichung von der Referenztemperatur zu ermitteln und entsprechende Korrekturfaktoren zu berücksichtigen.

Schließlich gibt es auch klimatisierte Messräume, in denen Waagen stehen. Hier werden die von Sensoren ermittelten Klimadaten des Messraumes in eine spezielle Software eingegeben. Diese ermittelt dann die entsprechenden Korrekturparameter, welche manuell oder automatisch in die Waage eingespeist werden.

All diese Maßnahmen sind allerdings für sich genommen nicht geeignet, die Messgenauigkeit beim Kalibrieren von Pipetten zu erhöhen, da die Sensoren bestenfalls in der näheren Umgebung der Waage platziert sind, nicht aber an oder in der Waage selbst.

Aufgabe der Erfindung ist es, eine Waage zu schaffen, die kompakt ist und mit geringerem Aufwand eine erhöhte Messgenauigkeit bei der Kalibrierung von Pipetten gewährleistet.

Zur Lösung dieser Aufgabe ist erfindungsgemäß eine Waage, die zur Pipettenkalibrierung ausgelegt ist, vorgesehen, mit einem Wägeraum, einem Windschutz, der den Wägeraum umgibt, einem Klimamodul, das einen Luftdrucksensor, einen Luftfeuchtesensor und einen Lufttemperatursensor enthält und abnehmbar in dem Wägeraum angeordnet ist, einem Prozessor, der in der Waage angeordnet ist und ausgebildet ist, einen Verdunstungsratenkorrekturwert bereitzustellen, beispielsweise durch Auslesen aus einer Verdunstungsratenkorrekturtabelle oder durch Berechnen, einer Dateneingabeeinheit, die an der Waage angeordnet ist, und einer Datenübertragungsstrecke, die ausgebildet ist, Daten zwischen dem Klimamodul und dem Prozessor auszutauschen.

Die Erfindung beruht auf dem Grundgedanken, die Genauigkeit des Kalibriervorgangs dadurch zu erhöhen, dass zum einen über das Klimamodul diejenigen Klimawerte bereitgestellt werden, die den Wägewert der Waage beeinflussen. Dies ermöglicht, den Wägewert direkt in der Waage geeignet zu korrigieren. Zum anderen kann die Waage selbst anhand der Klimawerte eine realistischere Verdunstungsrate innerhalb des Windschutzes ermitteln, die der Korrektur des Wägeergebnisses zugrundegelegt wird. Es muss dann nicht mit einer vordefinierten angenommenen Verdunstungsrate gearbeitet werden, sondern es kann mit einer individuellen aktuell bestimmten Verdunstungsrate gearbeitet werden, die im Hinblick auf die tatsächlichen Umgebungsbedingungen innerhalb des Windschutzes ausgehend von einer vordefinierten Annahme modifiziert ist oder auch völlig neu bestimmt werden kann.

Weiterhin ergibt sich der Vorteil, dass sämtliche Bauteile und Funktionen, die für eine Korrektur von Wägewerten nötig sind, in der Waage vereinigt sind. Es sind daher keine externen Computer, Sensoren, etc. notwendig. Stattdessen kann dem Benutzer ein kompaktes Messlabor an die Hand gegeben werden, das sogar transportabel ausgeführt sein kann. Da das Klimamodul austauschbar (also zerstörungsfrei von der Waage lösbar) ist, kann es nach Bedarf zu einem externen Institut bzw. Dienstleister zum Kalibrieren geschickt werden. In der Zwischenzeit kann die Waage weiter betrieben werden, indem ein Austausch-Klimamodul eingesetzt wird. Es kann also immer rollierend eines oder (bei mehreren Waagen) mehrere der Klimamodule beim Kalibrieren sein, während mit den übrigen Klimamodulen gemessen wird.

Hinsichtlich des Klimamoduls ergibt sich als weiterer Vorteil, dass ältere Waagen nachgerüstet werden können. Es muss hierzu neben der Datenübertragungsstrecke lediglich die Software des Prozessors ergänzt werden.

Hinsichtlich der Genauigkeit hat die erfindungsgemäße Waage den Vorteil, dass die Klimadaten im Windschutz (und nicht nur in dem Raum, in dem sich die Waage befindet) gemessen werden. Außerdem können, da die Klimadaten automatisch an den Prozessor übersandt werden, Übertragungsfehler praktisch ausgeschlossen werden, wie sie beim Übertragen von Werten aus dem sogenannten Kalibrierschein in die Kalibriersoftware nach der DE 299 12 867 U1 möglich sind.

Gemäß einer Ausführungsform ist vorgesehen, dass das Klimamodul mittels einer elektrischen Steckverbindung oder einer Funkverbindung mit dem Prozessor verbunden ist. Bei einer Steckverbindung kann diese in eine mechanische Aufnahme integriert sein, die zur Anbringung des Klimamoduls an der Waage dient. Auf diese Weise wird die Datenübertragungsstrecke zum Prozessor automatisch dann erstellt, wenn das Klimamodul innerhalb des Windschutzes an seinem Platz angeordnet wird. Bei einer Funkverbindung kann das Klimamodul an einer beliebigen Stellen innerhalb des Windschutzes angeordnet werden, beispielsweis an einer Seitenwand, an der es am wenigsten stört, ohne dass darauf Rücksicht genommen werden muss, ob an dieser Stelle sinnvoll eine Steckverbindung angeordnet werden kann. Außerdem ist der Verzicht auf eine Steckverbindung dahingehend vorteilhaft, dass der Innenraum der Wägekabine glatter und damit besser reinigbar ausgeführt werden kann.

Es kann zusätzlich vorgesehen sein, dass ein Sensor, welcher mit dem Prozessor gekoppelt ist, vorhanden ist und ausgebildet ist, den Ionisationsgrad im Wägeraum zu bestimmen. Dadurch kann ein zusätzlicher Parameter bestimmt und bei der Korrektur des Wägewerts berücksichtigt werden. Abhängig von dem bestimmten Ionisationsgrad wird vom Prozessor ein Ausgangssignal erzeugt, Ferner kann auch dass über eine Anzeige den Benutzer darauf hinweist, dass der lonisationsgrad innerhalb des Wägeraumes zu hoch ist und entsprechende Maßnahmen dagegen eingeleitet werden sollten.

Es kann auch vorgesehen sein, dass ein Lichtsensor im Wägeraum vorhanden ist, welcher mit dem Prozessor gekoppelt ist. Dadurch kann ein wiederum weiterer Parameter bestimmt und bei der Korrektur des Wägewerts berücksichtigt werden. Der Prozessor kann ab einem vorgegebenen Lichteinfall ein Ausgangssignal abgeben. Der Einfluss des Lichteinfalls auf den Wägeprozess ist damit bestimmbar, um gegebenenfalls Maßnahmen im Prozess selbst zu ergreifen. Das Ausgangssignal kann auch eine Anzeige sein.

Gemäß einer Ausführungsform kann vorgesehen sein, dass der Prozessor so ausgebildet ist, dass er auf Basis der Luftfeuchte und der Lufttemperatur im Wägeraum die Verdunstungsrate zumindest der Prüfflüssigkeit ermittelt. Auf diese Weise können vom Klimamodul metrologisch rückführbare Klimawerte zeitsynchron zur Übernahme des Massewertes erhalten werden, mit denen der Prozessor in der Lage ist, den Gewichtswert für die gravimetrische Kalibrierung des Nennvolumens einer Pipette zu korrigieren.

Vorzugsweise ist innerhalb des Windschutzes eine Verdunstungs- oder Feuchtigkeitsfalle angeordnet. Auf diese Weise kann die Luftfeuchtigkeit innerhalb des Windschutzes auf einen möglichst hohen Wert gebracht werden, so dass die Verdunstungsrate sinkt.

Gemäß einer Ausführungsform ist ein elektronischer Speicher vorgesehen, insbesondere ein EEPROM, der von außen auslesbar ist und auf dem Kalibrierwerte und Korrekturwerte für das Klimamodul abgelegt werden können. Zum Justieren können die Kalibrierwerte und Korrekturwerte auf einem elektronischen Speicher auf dem Klimamodul abgelegt werden, insbesondere auf einem EEPROM. Dies geschieht bei einem externen Dienstleister. Wenn das Klimamodul dann wieder an die Waage angekoppelt wird, stehen diese Daten dem Prozessor der Waage unmittelbar zur Verfügung. Zusätzlich können auf dem Speicher unter anderem zumindest einige der folgenden Informationen zur Sensorkalibrierung abgelegt werden: Nummer des Kalibrierscheins, aktuelle Kalibrierwerte, Kalibrierdatum, Name des Kalibrierlabors und des Bearbeiters sowie Kalibrierhistorie. Auf dem Speicher des Klimamoduls können auch sogenannte Unsicherheitswerte für jede Klimagröße abgelegt sein, sodass zum Beispiel zur Berechnung der Verdunstungsrate ebenso die Berechnung der Unsicherheit der Verdunstungsrate durch die Waage erfolgt.

Gemäß einer Ausgestaltung ist vorgesehen, dass das Klimamodul auch außerhalb einer Waage als selbständige Einheit einsetzbar ist und über einen I²C-Bus an einen USB-Port eines PC anschließbar ist. Dies erleichtert das externe Kalibrieren. Außerdem kann das Klimamodul in anderen Anwendungen dafür eingesetzt werden, Klimagrößen aufzunehmen, ohne dass es an eine Waage angeschlossen ist. Die Leiterplatte des Klimamoduls kann hierfür mit geringem Aufwand einen Steckfortsatz aufweisen, um an einen USB-Adapter angeschlossen werden zu können.

Zur Lösung der oben genannten Aufgabe ist erfindungsgemäß auch ein Verfahren zur Kalibrierung einer Pipette mit Hilfe einer Waage vorgesehen, bei dem während des Kalibriervorgangs eine Verdunstungsrate bestimmt und die Messung mittels in Abhängigkeit von der bestimmten Verdunstungsrate korrigiert wird. Auf diese Weise wird die Messgenauigkeit bzw. die Genauigkeit des Kalibriervorgangs erheblich gesteigert, da dem Kalibriervorgangs nicht eine (mehr oder weniger zutreffend) angenommene vordefinierte Verdunstungsrate zugrundegelegt werden muss, sondern ein realitätsnaher Wert, der von den aktuellen Klimabedingungen während des Kalibriervorgangs abhängt.

Gemäß einer Ausgestaltung kann vorgesehen sein, dass in Abhängigkeit von Klimaparametern, die vom Klimamodul bereitgestellt werden, eine vordefinierte Verdunstungsrate ausgewählt wird. Diese können beispielsweise in einer Datenbank innerhalb des Prozessors der Waage hinterlegt sein. Bei dieser Ausführungsform wird das Klima quasi in Gruppen eingeteilt und in Abhängigkeit von der jeweiligen Gruppe (in einem vereinfachten Beispiel: niedrige Luftfeuchtigkeit, mittlere Luftfeuchtigkeit, hohe Luftfeuchtigkeit) eine Verdunstungsrate gewählt, anhand der ein Korrekturfaktor für den Kalibriervorgangs bestimmt wird. Dabei kann auch die Temperatur einfließen, da auch sie einen Einfluss auf die Verdunstungsrate hat.

Gemäß einer alternativen Ausgestaltung kann vorgesehen sein, dass in Abhängigkeit von Klimaparametern, die vom Klimamodul bereitgestellt werden, eine tatsächliche Verdunstungsrate errechnet wird. Bei dieser Ausgestaltung wird vom Prozessor anhand der tatsächlichen Klimawerte eine tatsächliche Verdunstungsrate bestimmt.

Gemäß einer Ausführungsform ist vorgesehen, dass die Klimawerte während des gesamten Kalibrierungsvorgangs aufgenommen werden und der Korrekturfaktor auf Basis der Verdunstungsrate modifiziert wird, falls sich die Klimawerte so weit ändern, dass es angezeigt ist, der Korrektur des Kalibriervorgangs eine andere Verdunstungsrate zugrunde zu legen. Diese Ausführungsform führt zu einer nochmals gesteigerten Genauigkeit, da auch die Einflüsse kompensiert werden, die aus einer Änderung des Mikroklimas innerhalb des Windschutzes während des Kalibriervorgangs resultieren.

Weitere Merkmale und Vorteile der Erfindung ergeben sich aus der nachfolgenden Beschreibung und aus den nachfolgenden Zeichnungen, auf die Bezug genommen wird. In den Zeichnungen zeigen:
- Figur 1 eine Explosionsansicht einer erfindungsgemäßen Waage ,
- Figur 2 eine Perspektivansicht eines Klimamoduls, das bei der erfindungsgemäßen Waage eingesetzt werden kann,
- Figur 3 eine Seitenansicht des Klimamoduls nach Figur 2 ohne Außengehäuse,
- Figur 4 eine Draufsicht auf das Klimamodul von Figur 2, ebenfalls ohne Außengehäuse,
- Figur 5 schematisch eine erfindungsgemäße Waage, die mit einer Verdunstungsfalle versehen ist, und
- Figur 6 ein Ablaufdiagramm zur Pipettenkalibrierung mittels des erfindungsgemäßen Verfahrens.

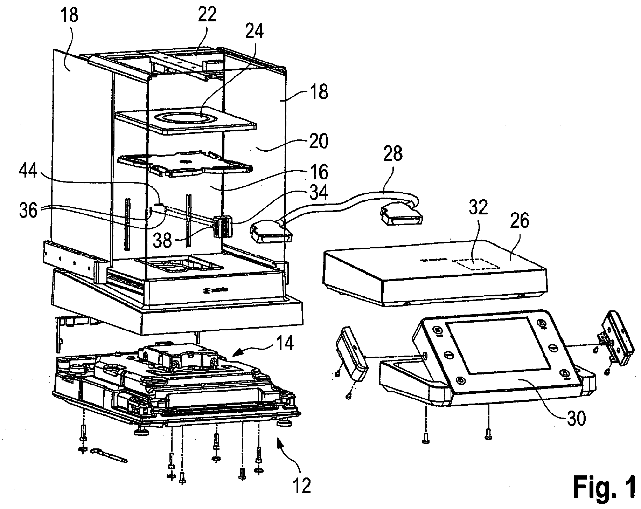

In Figur 1 ist eine hochauflösende elektronische Waage (Präzisionswaage) dargestellt, die beim Kalibrieren von Pipetten verwendet werden kann.

Die Waage umfasst eine Wägezelle 14 mit einer Basis 12, in welche ein nicht näher dargestelltes Wägesystem untergebracht ist. Die Wägezelle 14 umfasst darüber hinaus einen Wägeraum 16, der durch einen Windschutz mit verstellbaren Seitenwänden 18, einer Frontwand 20 sowie einer Rückwand 22 ausgebildet ist. Über den Windschutz ist der Wägeraum 16 zur Umgebung abgetrennt. Eine Waagschale 24 dient zum Auflegen des Wägeguts.

Ein hier als separates Teil ausgeführtes elektronisches Auswertesystem 26 ist über ein Kabel 28 mit der Wägezelle 14 elektronisch gekoppelt. Eine Anzeigeeinheit 30, die mit dem Auswertesystem 26 gekoppelt ist, dient sowohl als Anzeige als auch als Dateneingabeeinheit.

Im elektronischen Auswertesystem 26 ist unter anderem ein Prozessor 32 untergebracht, der Daten von der Wägezelle 14 erhält. Es beinhaltet weiterhin alle elektronischen Komponenten, die zum Betrieb der Waage notwendig sind.

Im Wägeraum 16 ist ein als baulich separate Einheit ausgeführtes Klimamodul 34 vorgesehen, welches über eine lösbare Steckverbindung mechanisch mit der Rückwand 22 koppelbar ist (also zerstörungsfrei lösbar angebracht ist), vorzugsweise ohne Zuhilfenahme eines Werkzeugs.

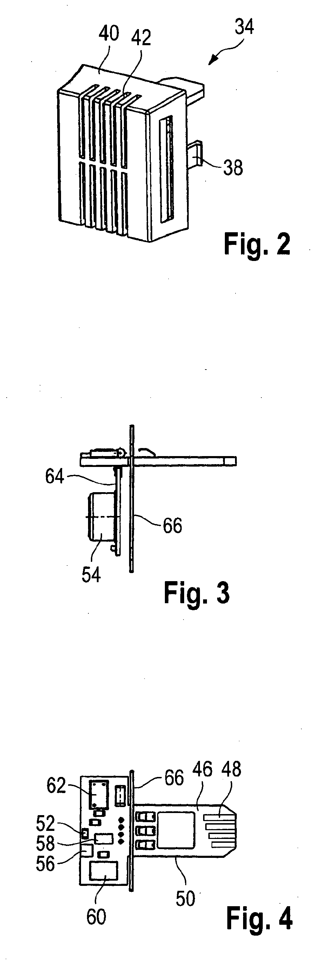

Hierzu weist die Rückwand 22 zwei von einander beabstandete Schlitze 36 auf, in die flexible Rasthaken 38 (siehe auch Figur 2) am Außengehäuse 40 des Klimamoduls einrasten.

In den Figuren 2 bis 4 ist das Klimamodul 34 näher dargestellt.

Das Außengehäuse 40 hat zahlreiche Öffnungen 42, über die das Innere des Außengehäuses 40 in den Wägeraum 16 übergeht und Teil des Wägeraums 16 wird, sodass das Klima im Inneren des Wägeraums 16 dem im Inneren des Außengehäuses 40 entspricht.

Das Klimamodul 34 ist elektronisch über eine elektrische Steckverbindung mit einer entsprechenden Steckeraufnahme 44 in der Rückwand 22 gekoppelt. Die Steckeraufnahme 44 steht elektrisch mit dem Prozessor 32 in Verbindung. In die Steckeraufnahme 44 wird ein Stecker 46 mit Kontakten 48 am Klimamodul 34 eingesteckt. Somit bildet der Stecker 46 einen modulseitigen Teil der elektrischen Steckverbindung.

Alternativ zu einer elektrischen Steckverbindung kann eine Funkübertragung, beispielsweise WLAN oder Bluetooth, verwendet werden.

Die elektrische Steckverbindung (oder die alternativverwendete Funkübertragung) bildet eine Datenübertragungsstrecke, mit der Daten vom Klimamodul 34 zum Prozessor 32 und ggfls. zurück übertragen werden können.

Der Stecker 46 ist vorzugsweise ein Abschnitt einer Leiterplatte 50, auf der mehrere Sensoren zum Erfassen des Klimas im Wägeraum 16 angeordnet sind. So sind ein Lufttemperatursensor52, ein Luftfeuchtesensor 54, ein unmittelbar in der Nähe einer Öffnung 42 angeordneter Lichtsensor 56 sowie ein Sensor 58 zum Erfassen des lonisationsgrads im Wägeraum 16 auf der Leiterplatte 50 vorgesehen, ebenso wie ein elektronischer Speicher 60. Ein Luftdrucksensor 62 ist über eine Halterung 64 mit der Leiterplatte 50 mechanisch und elektrisch gekoppelt.

Mehrere der Sensoren können auch zu kombinierten Sensoren zusammengefasst sein.

Eine Wand 66 schließt das schalenartige Au-ßengehäuse 40, sodass der schmale, zungenartige, in Figur 4 rechts von der Wand 66 liegende Abschnitt der Leiterplatte 50 in die Rückwand 22 und die Steckeraufnahme 44 einsteckbar ist.

Über entsprechende Kontakte 48 ist jeder Sensor mit dem Prozessor 32 gekoppelt. Ebenso ist der Speicher 60 mit dem Prozessor 32 gekoppelt.

Dann wird ein Wägegut auf die Waagschale 24 aufgelegt, also von einer Pipette so abgegeben, dass es auf die Waagschale 24 trifft.

Der Luftdruck, die Luftfeuchte und die Lufttemperaturwerden über die Sensoren 62, 54 bzw. 52 ermittelt, und die entsprechenden Daten werden an den Prozessor 32 weitergeleitet.

Darüber hinaus sind im Speicher 60 Kalibrierwerte und Korrekturwerte für das Klimamodul 34 abgelegt, die beim Kalibrieren des Klimamoduls 34 hinterlegt wurden.

Dieses Kalibrieren erfolgt außerhalb der Waage. Hierzu wird das Klimamodul 34 einfach vom Wägeraum 16 aus ausgesteckt, ohne dass eine Drahtverbindung gelöst werden müsste. Das Klimamodul 34 wird dann zu einem entsprechenden Kalibrierinstitut geschickt, das beispielsweise die Nummer des Kalibrierscheins, die neuen Kalibrierwerte, das Kalibrierdatum, den Namen des Kalibrierlabors und des Bearbeiters und die Kalibrierhistorie auf dem Speicher 60 ablegt. Diese Werte werden vom Applikationsprogramm später, wenn das Klimamodul 34 wieder in der Waage angeordnet ist, komplett oder teilweise ausgelesen und fließen direkt in die Berechnungen ein.

Auch die Werte des Lichtsensors 56 und des Sensors 58 zur Bestimmung des lonisationsgrads im Wägeraum 16 werden bestimmt.

Beispielsweise wird bei erhöhtem Lichteinfall ein entsprechendes Signal auf der Anzeige angegeben werden, dass beispielsweise die Messung aufgrund erhöhter Sonneneinstrahlung und damit veränderter Temperatur im Wägeraum ungenau ist. Somit wird vom Prozessorein Ausgangssignal abhängig vom Lichteinfall abgegeben.

Der Speicher 60 ist vorzugsweise ein EEPROM.

Darüber hinaus ist die Verbindung zwischen dem Klimamodul 34 und dem RestderWaage über einen I²C-BUS realisiert.

Das Klimamodul 34 kann über einen USB-Adapter, in den es eingesteckt wird, an einen Computer angeschlossen werden, um die Sensoren 52 bis 58 und 62 zu kalibrieren, ohne dass das Klimamodul 34 an die Waage 10 angeschlossen sein muss.

Wie zu erkennen ist, ist das Klimamodul so ausgebildet ist, dass es auch außerhalb einer Waage als selbständige Einheit einsetzbar ist und über einen I²C-Bus an einen USB-Port eines PC anschließbar ist.

Im Prozessor 32 ist eine Verdunstungsratenkorrekturtabelle hinterlegt. Diese Tabelle kann in einer einfachen Ausgestaltung als Wertetabelle hinterlegt sein, die unterschiedlichen Klimabedingungen unterschiedliche Verdunstungsraten zuordnet. In einer komplexeren Ausgestaltung kann die Verdunstungsratenkorrekturtabelle auch nach Art eines Kennfeldes ausgeführt sein, dem in Abhängigkeit von mehreren Klimaparametern, beispielsweise Temperatur und Feuchte, eine jeweils anzunehmende Verdunstungsrate hinterlegt ist. Es ist auch denkbar, dass die Verdunstungsratenkorrekturtabelle in der Form mathematischer Formeln hinterlegt ist, mit denen der Prozessor in Abhängigkeit von den jeweils aktuellen Klimadaten eine aktuell anzunehmende, tatsächliche Verdunstungsrate oder einen Verdunstungsratenkorrekturwert errechnet.

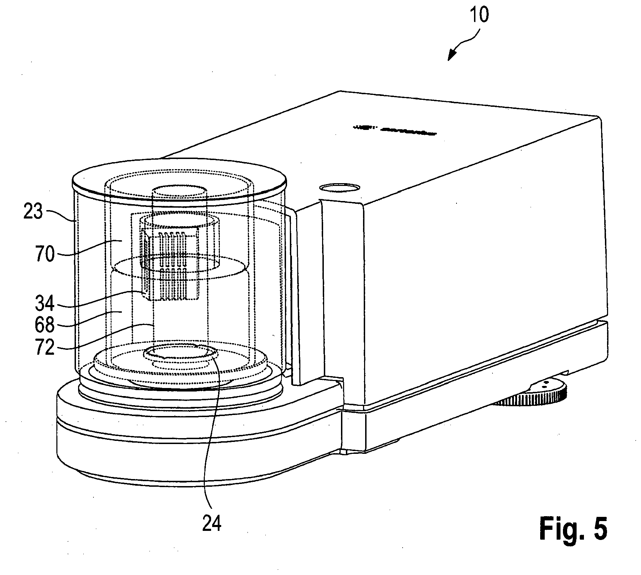

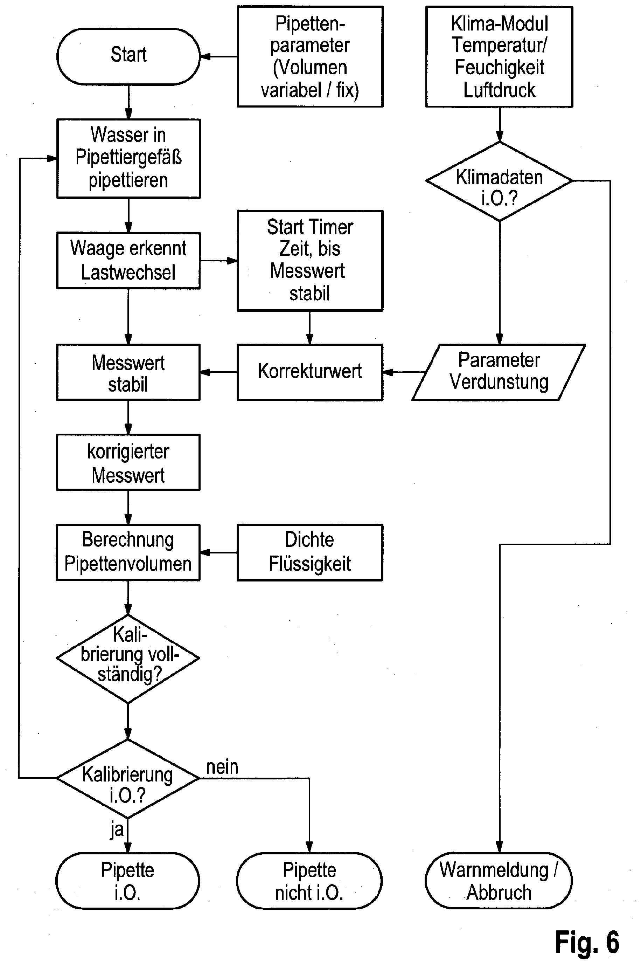

Anhand der Figuren 5 und 6 wird nachfolgend erläutert, wie mit der Waage mit Klimamodul eine Pipette kalibriert werden kann.

Bei der in Figur 5 gezeigten Waage 10 ist innerhalb eines hier zylindrisch ausgeführten Windschutzes 23 eine Verdunstungsfalle 68 angeordnet, die einen Aufnahmeraum 70 für eine Verdunstungsflüssigkeit, beispielsweise Wasser, enthält. Innerhalb der Verdunstungsfalle 68 ist ein Zylinder 72 angeordnet, der auf der Waagschale 24 ruht und der die zu pipettierende Flüssigkeit aufnimmt.

In Figur 6 ist als Ablaufdiagramm das Kalibrieren einer Pipette mit Korrektur des Einflusses der Verdunstung dargestellt.

Beim Start des Kalibrierungsvorgangs kann beispielsweise über die in Figur 5 nicht sichtbare Anzeigeeinheit 30 der Waage, wenn die Anzeigeeinheit als Touchscreen ausgeführt ist und somit als Dateneingabeeinheit dient, die nötigen Pipettenparameter eingegeben werden, beispielsweise das Volumen oder auch die verwendete Kalibrierflüssigkeit.

Wenn dann ein zu wiegendes Flüssigkeitsvolumen in den Zylinder 72 pipettiert wird, erkennt die Waage einen Lastwechsel, der den Messvorgang auslöst. Gleichzeitig können vom Klimamodul 34 die Klimadaten abgefragt werden. Nach einer Vorprüfung, ob diese grundsätzlich plausibel sind, berechnetder Prozessor32 unter Zuhilfenahme der Verdunstungsratenkorrekturtabelle eine angenommene Verdunstungsrate. Diese wird dazu verwendet, den ermittelten Wägewert unter Berücksichtigung der Verdunstung der Pipettierflüssigkeit zu korrigieren.

Gleichzeitig kann der Prozessor 32 unter Berücksichtigung der Klimaparameter errechnen, in welcher Weise diese den Wägewert unabhängig von der Verdunstungsrate beeinflussen, d.h. beispielsweise die Messunsicherheit der Waage beeinflussen. Die Messunsicherheit kann angezeigt oder mittels eines Protokolls ausgegeben werden.

Anhand des so korrigierten Wägewerts kann das Volumen der zu kalibrierenden Pipette sehr präzise berechnet werden. Falls nach der aktuellen Messung die Kalibrierung noch nicht vollständig ist, wird ein weiterer Pipettiervorgang angefordert. Daraufhin wiederholt sich der Vorgang des Einschwingens derWaage und des Korrigierens des aktuell ermittelten Wägewerts. Bei dieser Korrektur wird wieder das aktuell tatsächlich vorhandene Klima berücksichtigt. Falls sich also beispielsweise die Feuchte im Wägeraum zwischen der ersten und der zweiten Messung geändert hat, wird auch eine geänderte Verdunstungsrate berücksichtigt. Auf diese Weise ergibt sich eine sehr hohe Präzision der Messung. Wenn dieser Vorgang abgeschlossen ist, wird entschieden, ob die Pipette die jeweiligen Anforderungen erfüllt (in diesem Fall wird die Pipette als in Ordnung eingestuft) oder nicht (in diesem Fall wird die Pipette als nicht in Ordnung eingestuft und es werden weitergehende Maßnahmen, wie beispielsweise eine Reparatur, eingeleitet).

## Patentansprüche

1. Waage, die zur Pipettenkalibrierung ausgelegt ist, mit einem Wägeraum (16), einem Windschutz (23), der den Wägeraum (16) umgibt, einem Klimamodul (34), das einen Luftdrucksensor (62), einen Luftfeuchtesensor (54) und einen Lufttemperatursensor (52) enthält und abnehmbar in dem Wägeraum (16) angeordnet ist, einem Prozessor (32), der in der Präzisionswaage angeordnet ist und ausgebildet ist, einen Verdunstungsratenkorrekturwert bereitzustellen, einer Dateneingabeeinheit, die an der Waage angeordnet ist, und einer Datenübertragungsstrecke, die ausgebildet ist, Daten zwischen dem Klimamodul (34) und dem Prozessor (32) auszutauschen.

2. Waage nach Anspruch 1, **dadurch gekennzeichnet, dass** der Prozessor (32) ausgebildet ist, den Verdunstungsratenkorrekturwert einer Verdunstungsratenkorrekturtabelle zu entnehmen oder ihn zu berechnen.

3. Waage nach Anspruch 1 oder Anspruch 2, **dadurch gekennzeichnet, dass** das Klimamodul (34) mittels einerelektrischen Steckverbindung oder einer Funkübertragung mit dem Prozessor (32) verbunden ist.

4. Waage nach einem der vorhergehenden Ansprüche, **dadurch gekennzeichnet, dass** ein Sensor (58), welcher mit dem Prozessor (32) gekoppelt ist, vorhanden ist und ausgebildet ist, den Ionisationsgrad im Wägeraum (16) zu bestimmen.

5. Waage nach einem der vorhergehenden Ansprüche, **dadurch gekennzeichnet, dass** ein Lichtsensor (56) im Wägeraum (16) vorhanden ist, welcher mit dem Prozessor (32) gekoppelt ist.

6. Waage nach einem der vorhergehenden Ansprüche, **dadurch gekennzeichnet, dass** der Prozessor(32) so ausgebildet ist, dass er auf Basis der Klimaparameter im Wägeraum (16) die Messunsicherheit ermittelt.

7. Waage nach einem der vorhergehenden Ansprüche, **dadurch gekennzeichnet, dass** innerhalb des Windschutzes eine Verdunstungsfalle angeordnet ist.

8. Verfahren zur Kalibrierung einer Pipette mit Hilfe einer Waage nach einem der Ansprüche 1 bis 7, **dadurch gekennzeichnet, dass** während des Kalibriervorgangs eine Verdunstungsrate bestimmt und die Messung in Abhängigkeit von der bestimmten Verdunstungsrate korrigiert wird.

9. Verfahren nach Anspruch 8, **dadurch gekennzeichnet, dass** in Abhängigkeit von Klimaparametern, die vom Klimamodul bereitgestellt werden, eine von vordefinierten Verdunstungsraten ausgewählt wird.

10. Verfahren nach Anspruch 8, **dadurch gekennzeichnet, dass** in Abhängigkeit von Klimaparametern, die vom Klimamodul bereitgestellt werden, eine tatsächliche Verdunstungsrate errechnet wird.

11. Verfahren nach einem der Ansprüche 8 bis 10, **dadurch gekennzeichnet, dass** die Klimaparameter während des gesamten Kalibrierungsvorgangs aufgenommen werden und die Verdunstungsrate modifiziert wird, falls sich die Klimaparameter so weit ändern, dass es angezeigt ist, der Korrektur des Kalibrierungsvorgangs eine andere Verdunstungsrate zugrunde zu legen.

## Claims

1. Weighing machine designed for pipette calibration, with a weighing chamber (16), a draught protector (23) enclosing the weighing chamber (16), a climate module (34) which includes an air pressure sensor (62), a humidity sensor (54) and an air temperature sensor (52) and which is removably arranged in the weighing chamber (16), a processor (32) arranged in the precision weighing machine and configured to provide an evaporation rate correction value, a data input unit arranged at the weighing machine, and a data transmission path configured to exchange data between the climate module (34) and the processor (32).

2. Weighing machine according to claim 1, **characterised in that** the processor (32) is configured to extract the evaporation rate correction value from an evaporation rate correction table or to calculate it.

3. Weighing machine according to claim 1 or claim 2, **characterised in that** the climate module (34) is connected with the processor (32) by means of an electrical plug connection or by means of radio transmission.

4. Weighing machine according to any one of the preceding claims, **characterised in that** a sensor (58) coupled with the processor (32) is present and is configured to determine the degree of ionisation in the weighing chamber (16).

5. Weighing machine according to any one of the preceding claims, **characterised in that** a light sensor (56) coupled with the processor (32) is present in the weighing chamber (16).

6. Weighing machine according to any one of the preceding claims, **characterised in that** the processor (32) is so configured that it determines the measuring uncertainty on the basis of the climate parameters in the weighing chamber (16).

7. Weighing machine according to any one of the preceding claims, **characterised in that** an evaporation trap is arranged within the draught protector.

8. Method for calibrating a pipette with the help of a weighing machine according to any one of claims 1 to 7, **characterised in that** during the calibration process an evaporation rate is determined and the measurement is corrected in dependence on the determined evaporation rate.

9. Method according to claim 8, **characterised in that** one of pre-defined evaporation rates is selected in dependence on climate parameters provided by the climate module.

10. Method according to claim 8, **characterised in that** an actual evaporation rate is calculated in dependence on climate parameters provided by the climate module.

11. Method according to any one of claims 8 to 10, **characterised in that** the climate parameters are recorded during the entire calibration process and the evaporation rate is modified if the climate parameters change to such an extent that it is indicated to base the correction of the calibration process on a different evaporation rate.

## Revendications

1. Balance conçue pour l'étalonnage de pipettes, comprenant une chambre de pesée (16), un paravent (23) qui entoure la chambre de pesée (16), un module de climatisation (34) qui contient un capteur de pression d'air (62), un capteur d'humidité (54) et un capteur de température d'air (52) et qui est agencé dans la chambre de pesée (16) de manière amovible, un processeur (32), qui est agencé dans la balance de précision et qui est conçu pour fournir une valeur de correction de taux d'évaporation, une unité d'entrée de données, qui est agencée sur la balance, et une voie de transmission de données qui est conçue pour échanger des données entre le module de climatisation (34) et le processeur (32).

2. Balance selon la revendication 1, **caractérisée en ce que** le processeur (32) est conçu pour déduire la valeur de correction de taux d'évaporation d'un tableau de correction de taux d'évaporation ou pour calculer celle-ci.

3. Balance selon la revendication 1 ou la revendication 2, **caractérisée en ce que** le module de climatisation (34) est relié au processeur (32) au moyen d'une connexion enfichable électrique ou d'une transmission radio.

4. Balance selon l'une quelconque des revendications précédentes, **caractérisée en ce qu'**un capteur (58), lequel est couplé au processeur (32), est présent et conçu pour déterminer le degré d'ionisation dans la chambre de pesée (16).

5. Balance selon l'une quelconque des revendications précédentes, **caractérisée en ce qu'**un capteur de lumière (56), lequel est couplé au processeur (32), est présent dans la chambre de pesée (16).

6. Balance selon l'une quelconque des revendications précédentes, **caractérisée en ce que** le processeur (32) est conçu de manière à établir l'incertitude de mesure sur la base des paramètres de climatisation dans la chambre de pesée (16).

7. Balance selon l'une quelconque des revendications précédentes, **caractérisée en ce qu'**un piège anti-évaporation est agencé à l'intérieur du paravent.

8. Procédé d'étalonnage d'une pipette à l'aide d'une balance selon l'une quelconque des revendications 1 à 7, **caractérisé en ce qu'**un taux d'évaporation est déterminé pendant la procédure d'étalonnage et la mesure est corrigée en fonction du taux d'évaporation déterminé.

9. Procédé selon la revendication 8, **caractérisé en ce qu'**un des taux d'évaporation prédéfinis est sélectionné en fonction des paramètres de climatisation qui sont fournis par le module de climatisation.

10. Procédé selon la revendication 8, **caractérisé en ce qu'**un taux d'évaporation effectif est calculé en fonction des paramètres de climatisation qui sont fournis par le module de climatisation.

11. Procédé selon l'une quelconque des revendications 8 à 10, **caractérisé en ce que** les paramètres de climatisation sont enregistrés pendant toute la procédure d'étalonnage et le taux d'évaporation est modifié au cas où les paramètres de climatisation varieraient à un point tel qu'il serait indiqué de prendre un autre taux d'évaporation pour base de la correction de la procédure d'étalonnage.
